# EUROPÄISCHE PATENTSCHRIFT

(11) **EP 2 193 692 B1**
(45) Veröffentlichungstag und Bekanntmachung des Hinweises auf die Patenterteilung: **09.11.2016**
(21) Anmeldenummer: 08802130.8
(22) Anmeldetag: 12.09.2008
(51) Int. Cl.: H05B 33/14, C09K 11/06, H01L 51/54, H01L 51/00, H01L 51/50

(54) **POLYMERE LICHT-EMITTIERENDE DIODE UND VERFAHREN ZU DEREN HERSTELLUNG**
POLYMER LIGHT-EMITTING DIODE AND METHOD FOR THE PRODUCTION THEREOF
DIODE ÉLECTROLUMINESCENTE POLYMÈRE ET SON PROCÉDÉ DE FABRICATION

(30) Priorität: 20.09.2007 DE 102007044872
(43) Veröffentlichungstag der Anmeldung: 09.06.2010
(73) Patentinhaber: Fraunhofer-Gesellschaft zur Förderung der angewandten Forschung e.V., 80686 München (DE)
(72) Erfinder: KRÜGER, Hartmut, 12163 Berlin (DE); THESEN, Manuel, 10627 Berlin (DE); JANIETZ, Silvia, 14532 Stahnsdorf (DE); WEDEL, Armin, 14513 Teltow (DE)
(74) Vertreter: Pfenning, Meinig & Partner mbB
(86) Internationale Anmeldenummer: PCT/EP2008/007578
(87) Internationale Veröffentlichungsnummer: WO 2009/040000

(56) Entgegenhaltungen:
- EP-A- 1 311 138
- EP-A- 1 516 901
- EP-A- 1 591 511
- EP-A1- 2 117 062

## Beschreibung

Die Erfindung betrifft polymere Licht emittierende Dioden (PLEDs) enthaltend mindestens eine transparente Elektrode als Anode, mindestens eine Metallelektrode als Kathode sowie ein organisches, Licht emittierendes Mehrschichtsystem aus thermisch vernetzten Polymerschichten sowie ein Verfahren zu deren Herstellung.

Üblicherweise wird für den Aufbau von aus Lösung herstellbaren phosphoreszenten polymeren Licht emittierenden Dioden (PhPLEDs) ein Blendkonzept angewendet, das in einer polymeren Matrix, z.B. Poly-(N-vinylcarbazol) (PVK) einen phosphoreszenten Emitter (organische Übergangsmetall-Komplexe, z.B. Tris(2-(4tolyl)phenylpyridin)iridium(Ir(mppy)₃), ein Elektronentransportmolekül (2-(4-Biphenyl)-5-(4-tert.-butyl)-1,3,4-oxadiazol) (PBD) und zur Verbesserung der Lochinjektion zusätzlich ein Lochtransportmolekül (z.B.: N,N'-diphenyl-N,N'-(bis(3-methylphenyl)-[1,1biphenyl]-4,4'-diamin (TPD)) einmischt. Daraus resultieren Guest-Host-Systeme, die unterschiedliche Gehalte der Komponenten aufweisen. Ein hocheffizientes System beinhaltet 25 Ma% PBD, 9 Ma% TPD und 6 Ma% eines grün emittierenden Ir-Komplexes (Ir(mppy)₃). Der Aufbau von Licht emittierenden Dioden mit diesem phosphoreszenten Blendsystem als Schicht zwischen einer mit Poly(ethylendioxythiophen)/Poly(styrensulfonat) (PEDOT:PSS) beschichteten ITO-Anode und einer mit einer ultradünn CsF-beschichteten Al-Kathode führt zu PPLEDs mit einer externen Quanteneffizienz von 10,7 % und einer "power conversion efficiency" von 24 lm/W bei ∼ 100 cd/m² [X.H. Yang, D. Neher, Applied Physical Letters 2004, 84, 2476-2478].

Solche Blendsysteme weisen häufig für Anwendungen in PhPLEDs die nachteilige Eigenschaft auf, dass die Komponenten unter Betriebsbedingungen der PhPLED in der polymeren Matrix aggregieren, migrieren und/oder separate Phasen bilden können. Weiterhin ist die Löslichkeit der Komponenten in der Matrix häufig beschränkt, so dass sich eine optimale Zusammensetzung und ein optimaler Gehalt nicht mehr einstellen lassen. Eine Weiterentwicklung des eingesetzten Blendsystems besteht also darin, dass das Lochtransportmolekül, das Elektronentransportmolekül und der phosphoreszente Farbstoff an ein Polymersystem kovalent gebunden werden. Als inertes Polymersystem wurde Polystyren ausgewählt [M. Suzuki, S. Tokito, F. Sato, Applied Physical Letters 2005, 86, 103507].

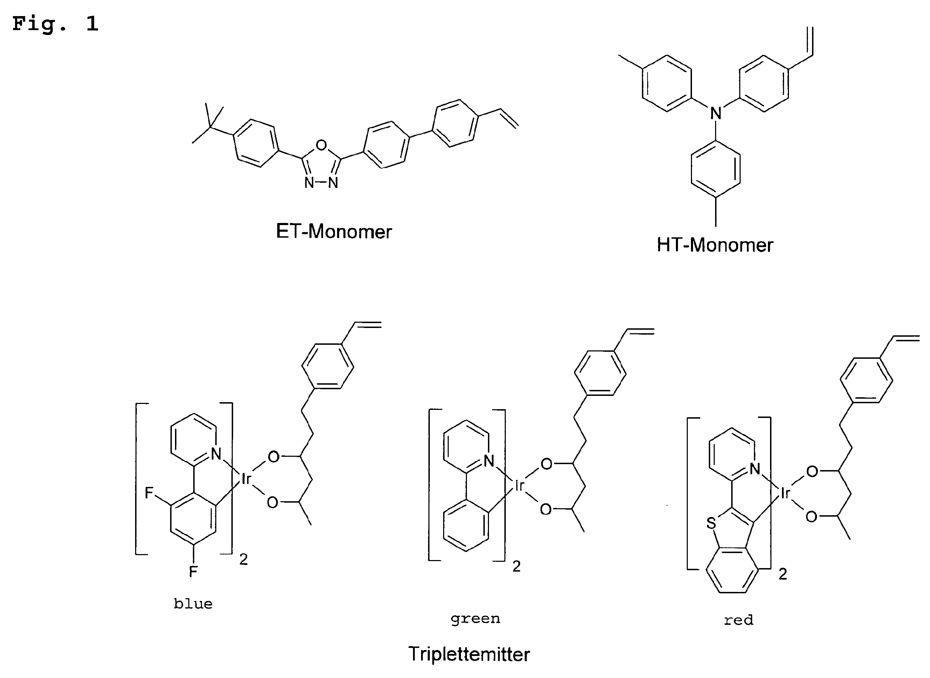

Dazu wurden zunächst die Monomerbausteine, wie das Lochtransportmolekül (N,N'-diphenyl-N,N'-(bis(3methylphenyl)-[1,1-biphenyl]-4,4'-diamin (TPD), das Elektronentransportmolekül (2-(4-Biphenyl)-5-(4-tert-butyl)-1,3,4-oxadiazol (PBD) und der grün phosphoreszierende Triplettemitter (Bis(2-phenylpyridin)iridium-(acetylacetonat) (Ir(ppy)₂(acac)), mit einer Styren- oder Vinylgruppe funktionalisiert. Diese wurden dann in unterschiedlichen Zusammensetzungen radikalisch copolymerisiert. Effiziente Copolymere enthielten beispielsweise 18 Mol% TPD, 79 Mol% PBD und 3 Mol% Ir(ppy)₂(acac). Die PhPLEDs wurden daraus wie folgt aufgebaut: Zunächst wurde eine 35 nm dicke Schicht von Poly(ethylendioxythiophen)/Poly(styrensulfonat) (PEDT/PSS) auf ITO mittels Spincoating aufgebracht, danach dann das phosphoreszente Copoly-(styren) aus der Lösung als Schicht abgeschieden und anschließend Cs/Al als Kathodenmaterial aufgedampft. In solcher Weise aufgebaute PhPLEDs erzielten Quanteneffizienzen von 11,8 % und "power efficiencies" von 38.6 lm/W. Durch Variation der Liganden am Ir-Komplex, wie aus der Literatur bekannt, lassen sich dann auch unterschiedliche Farben realisieren. Für die Herstellung solcher PhPLEDs in den Farben rot, grün und blau wurden die in Fig. 1 dargestellten styrenfunktionalisierten Comonomere eingesetzt.

Die Copolymerzusammensetzung war für alle 3 realisierten Farben ähnlich. Die optimierten Copolymere enthielten ca. 70 Mol% PBD als Elektronentransportmonomer, ca. 26 Mol% 4,4'-Dimethyltriphenylamin (DTA) und ca. 4 Mol% Ir-Komplexe. PhPLEDs die damit aufgebaut wurden, zeigten die in der Tabelle 1 zusammengefasste Performance.

**Tabelle 1**

| Polymer | cd/m² | cd/A |
|---|---|---|
| Grün(MT313) | 5000 @ 10 V | 28 @8 V |
| Rot (MT317) | 700 @ 8 V | 6,5 @ 8 V |
| Blau (MT318) | 650 @ 9 V | 4,5 @ 6 V |

Diese Parameter für die unterschiedlichen Farben gehören mit zu den besten Werten für phosphoreszente PLEDs. Ein allgemeines, bekanntes Problem dieser aus einer aktiven Einfachschicht hergestellten PhPLEDs ist ihre geringe Betriebslebensdauer.

Ausgehend hiervon war es Aufgabe der vorliegenden Erfindung, phosphoreszente, Licht emittierende Dioden bereitzustellen, die gegenüber den aus dem Stand der Technik bekannten Systemen eine verbesserte Effizienz und Lebensdauer aufweisen. Ebenso soll ein Verfahren zur Herstellung derselben bereitgestellt werden, das sich durch eine einfache Handhabung auszeichnet.

Diese Aufgabe wird durch das Verfahren zur Herstellung polymerer Licht emittierender Dioden mit den Merkmalen des Anspruchs 1 und durch die polymeren Licht emittierenden Dioden mit den Merkmalen des Anspruchs 11 gelöst. Die weiteren abhängigen Ansprüche zeigen vorteilhafte Weiterbildungen auf.

Erfindungsgemäß wird ein Verfahren zur Herstellung polymerer Licht emittierender Diode bereitgestellt, das folgende Schritte aufweist:
a) Aufbringen einer ersten Lösung enthaltend mindestens ein Lochtransportermaterial und mindestens ein thermisch vernetzbares Polymer auf eine transparente Anode,
b) thermische Vernetzung der Polymere unter Ausbildung einer ersten Schicht,
c) Aufbringen einer zweiten Lösung enthaltend mindestens einen Phosphoreszenzemitter und mindestens ein thermisch vernetzbares Polymer auf der ersten Schicht,
d) thermische Vernetzung der Polymere unter Ausbildung einer zweiten Schicht und
e) zumindest bereichsweises Aufbringen mindestens eines Metalls als Kathodenmaterial auf der zweiten Schicht.

Aus dem Stand der Technik ist es bekannt, dass durch Anwendung von Verdampfungstechnologien kleiner organischer Moleküle Multischichten für den Aufbau von phosphoreszenten organischen Leuchtdioden mit langer Lebensdauer erzeugt werden können. Von den durch Aufdampfen erzeugten Multischichtsystemen kleiner Moleküle ist bekannt, dass durch die Separation von Lochtransport, Emission und Elektronentransport in separaten Schichtenabfolgen, eine wesentliche Verbesserung von Effizienz und Lebensdauer dieser Dioden erzielt werden kann. Durch die erfindungsgemäße Verwendung von vernetzbaren Polymermatrizes mit kovalent gebundenen Ladungs-transportierenden und phosphoreszenten Seitengruppen ist nunmehr ebenfalls ein störungsfreier Multischichtaufbau zur Separation von Lochtransport, Emission und Elektronentransport möglich und bei entsprechender Optimierung von einzelschichtigen Zusammensetzungen der vernetzbaren Copolymere eine Verbesserung von Performance und Lebensdauer der daraus hergestellten Dioden.

Vorzugsweise werden wir Lösungen durch Spincoating, Rakeln und/oder Drucktechniken aufgebracht. Die Lösungen können vorzugsweise auf festen Trägerstrukturen, z.B. ITO auf Glassubstraten, oder auf flexiblen leitfähigen Trägermaterialien aufgebracht werden.

Vorzugsweise ist vor Schritt a) die transparente Anode auf einem Substrat abgeschieden worden. Das Substrat kann aus Glas oder einem Polymermaterial bestehen oder dieses im Wesentlichen enthalten. Weiterhin kann die transparente Anode aus Indium-Zinn-Oxid (ITO) oder anderen transparenten Metalloxiden bestehen oder dieses im Wesentlichen enthalten.

Die Verfahrensführung sieht grundsätzlich zwei Varianten vor.

Bei der ersten Variante werden Copolymere hergestellt, die wahlweise lochtransportierende, elektronentransportierende und Phosphoreszenz-emittierende Einheiten tragen, sowie zur Vernetzung befähigte Epoxy- und phenolische Gruppen aufweisen. Diese Polymerschichten werden anschließend mittels eines Temperprozesses vernetzt. Dabei kann die Vernetzung der Glycidylgruppen der Copolymere entweder ohne Zusatz weiterer Komponenten, z.B. bei Vorhandensein phenolischer Gruppen im Copolymer, oder durch Zugabe von Polymeren mit phenolischen, Carboxyl- oder auch primären und sekundären Arylamingruppen oder durch Zugabe entsprechender niedermolekularer Phenole, Carbonsäuren, Carbonsäureanhydriden oder auch primärem und sekundärem Arylamin thermisch ausgeführt werden. Auf diese erste Schicht, die vorzugsweise ein Lochtransportmaterial enthält, kann dann ohne Anlösen der ersten aufgebrachten Schicht eine zweite organolösliche polymere Schicht aufgebracht werden. Diese enthält bevorzugt den Phosphoreszenzemitter und wahlweise Elektronen- bzw. Lochtransporteinheiten. Bei entsprechender Vernetzbarkeit dieser Schicht, kann auf diese eine weitere, z.B. Elektronentransport, aufgebracht werden.

Eine zweite Variante sieht vor, dass die Lochtransportmaterialien, Elektronentransportmaterialien oder Phosphoreszenzemitter nicht kovalent an die Polymermatrix gebunden werden, sondern der Lösung zugemischt werden, so dass diese Komponenten anschließend als Blend in den einzelnen Schichten vorliegen. Diese Verfahrensweise bietet sich insbesondere bei hochvernetzbaren Polymermatrizes an.

Die Vernetzung der einzelnen Schichten erfolgt thermisch, wobei dieses gegenüber anderen Vernetzungsverfahren ohne zusätzliche Initiatoren erfolgen kann, die als störende Verunreinigung in den Schichten verbleiben würden. Durch die thermische Vernetzung wird die lösliche, insbesondere organolösliche polymere Schicht in eine unlösliche Form überführt. Dadurch kann dann eine zweite organolösliche polymere Schicht abgeschieden werden, ohne die zuvor abgeschiedene unterliegende Schicht zu beeinträchtigen.

Der mindestens eine Phosphoreszenzemitter ist vorzugsweise ausgewählt aus der Gruppe bestehend aus organischen Metallkomplexen mit Zentralatomen der Elemente Re, Ir, Pt, Eu, Ru, Komplexen von anderen Seltenerdmetallen und deren Mischungen.

Das Lochtransportmaterial ist vorzugsweise ausgewählt aus der Gruppe bestehend aus Arylaminen, insbesondere NPD oder TPD, aber auch höherkondensierte Arylamine, Carbazole, carbazolsubstituierte Verbindungen und Mischungen hiervon.

Das Elektronentransportmaterial ist vorzugsweise ausgewählt aus der Gruppe bestehend aus Oxadiazolen, Triazolen, Chinoxalinen, Chinolinen, Phenanthrenen, Bathocuproinen, Benzimidazolen und Mischungen hiervon.

Erfindungsgemäß wird ebenso eine polymere Licht emittierende Diode (PLED) bereitgestellt, die mindestens eine transparente Elektrode als Anode, mindestens eine Metallelektrode als Kathode sowie ein organisches, Licht emittierendes Mehrschichtsystem aus thermisch vernetzten Polymerschichten enthält. Das Schichtsystem weist dabei mindestens eine erste, ein Lochtransportmaterial enthaltende Schicht und eine zweite, mindestens einen Phosphoreszenzemitter enthaltende Schicht auf.

Durch die Vernetzbarkeit der einzelnen Schichten ist die hinsichtlich Lebensdauer und Effizienz vorteilhafte Trennung von Loch- und Elektronentransport sowie phosphoreszenter Emission möglich.

In einer bevorzugten Ausführungsform sind das Lochtransportmaterial und/oder der Phosphoreszenzemitter kovalent an das thermisch vernetzte Polymer gebunden.

Ebenso ist es aber möglich, dass das Lochtransportmaterial und/oder der Phosphoreszenzemitter als Blend in dem thermisch vernetzten Polymer vorliegt, wobei das Polymer derart hoch vernetzt ist, dass eine Migration oder Aggregation des Lochtransportmaterials und/oder des Phosphoreszenzemitters im Polymer verhindert wird. Bei dieser geblendeten Variante ist das thermisch vernetzte bzw. vernetzbare Polymer vorzugsweise ein im sichtbaren Bereich nicht emittierendes Polymer, das vorzugsweise ausgewählt ist aus der Gruppe der Polystyrole. Das vernetzte Polymer wurde dabei vorzugsweise über Epoxygruppen, phenolische oder aminische Funktionalitäten vernetzt.

Vorzugsweise ist die erste Schicht benachbart zur transparenten Anode angeordnet. Die erste Schicht kann dabei bevorzugt zusätzlich mindestens einen Phosphoreszenzemitter enthalten.

Die zweite Schicht ist bevorzugt auf der der transparenten Anode abgewandten Seite der ersten Schicht angeordnet und kann bevorzugt zusätzlich mindestens ein Elektronentransportmaterial und/oder mindestens ein Lochtransportmaterial enthalten.

Eine weitere bevorzugte Variante sieht vor, dass das Schichtsystem eine dritte Schicht aufweist, die auf der der ersten Schicht abgewandten Seite der zweiten Schicht angeordnet ist. Diese dritte Schicht enthält vorzugsweise mindestens einen Phosphoreszenzemitter und/oder mindestens ein Elektronentransportmaterial.

Bevorzugt ist der mindestens eine Phosphoreszenzemitter ausgewählt aus der Gruppe bestehend aus organischen Metallkomplexen mit Zentralatomen der Elemente Re, Ir, Pt, Eu, Ru, Komplexen von anderen Seltenerdmetallen und/oder deren Mischungen.

Das Lochtransportmaterial kann ausgewählt sein aus der Gruppe bestehend aus Arylaminen, Carbazole, carbazolsubstituierte Verbindungen und Mischungen hiervon.

Das Elektronentransportmaterial ist bevorzugt ausgewählt aus der Gruppe bestehend aus Oxadiazolen, Triazolen, Chinoxalinen, Chinolinen, Phenanthrenen, Bathocuproinen, Benzimidazolen und Mischungen hiervon.

Die Schichten weisen vorzugsweise eine Dicke im Bereich von 10 bis 500 nm, insbesondere 10 bis 100 nm auf.

Die transparente Anode besteht vorzugsweise aus Indium-Zinn-Oxid (ITO) oder anderen transparenten Metalloxiden oder enthält dieses im Wesentlichen.

Ebenso kann die polymere Licht emittierende Diode ein Substrat aufweisen, die vorzugsweise aus Glas oder einem Polymermaterial besteht oder dieses im Wesentlichen enthält.

Anhand der nachfolgenden Figuren und Beispiele soll der erfindungsgemäße Gegenstand näher erläutert werden, ohne diesen auf die hier gezeigten speziellen Ausführungsformen einschränken zu wollen.

### Beispiel 1

### Synthese der Monomere

### 1.1 Synthese von 2-(4-Vinyl-phenoxymethyl)-oxiran

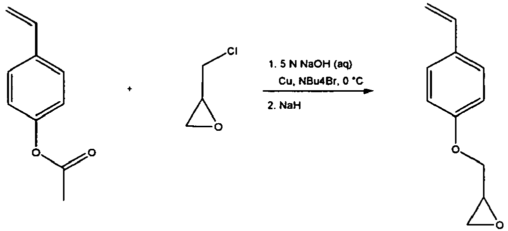

In einen 500 ml Dreihalsrundkolben, der mit Thermometer, KPG-Flügelrührer, Inertgaseinleitung und Tropftrichter ausgestattet ist, werden 40,0 ml 4-Acetoxystyren (0,22 mol), 36,4 ml Epichlorhydrin (0,47 mol), 0,38 g Kupferpulver (5,98 · 10⁻³ mol) und 0,38 g Tetrabutylammoniumbromid (1,18 · 10⁻³ mol) vorgelegt und auf 5 °C gekühlt. 110 ml 5 N Natronlauge sind bei starkem Rühren über den Tropftrichter so zuzugeben, dass die Temperatur der Reaktionsmischung 7 °C nicht übersteigt. Nach erfolgter Zugabe wird für ca. 24 h bei 5 °C gerührt, anschließend die Phasen separiert und die wässrige Phase mit Diethylether extrahiert. Die vereinten organischen Phasen werden zweimal mit Wasser gewaschen und über Natriumsulfat getrocknet. Nach vorsichtiger Zugabe von 3,5 g Natriumhydrid (0,15 mol) wird eine Stunde bei Raumtemperatur gerührt und anschließend filtriert. Die etherische Lösung wird erneut über Natriumsulfat getrocknet, das Trockenmittel abgesaugt und das Lösemittel am Rotationsverdampfer abgezogen. Durch säulenchromatographische Trennung des Rohproduktes über Kieselgel mit dem Eluenten Hexan/Methylenchlorid in einem Verhältnis von 1:1 sind 2 g (5 %) sauberes Produkt in Form eines farblosen Öles zugänglich.
Elementaranalyse: C 74,91 %; H 6,31 %; N 0,34 %

### 1.2 Synthese von 4-Vinylphenol

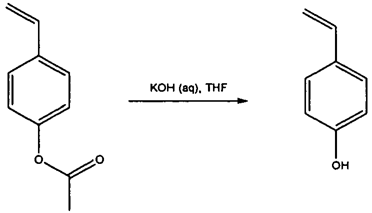

In einen 100 ml Dreihalsrundkolben werden 5,0 g 4-Acetoxystyren (3,08 10⁻² mol) in 20 ml Tetrahydrofuran, 1,73 g Kaliumhydroxid (3,08 · 10⁻² mol) in 15 ml Wasser und eine Spatelspitze Tetrabutylammoniumbromid vorgelegt und für ca. 20 h bei Raumtemperatur gerührt. Danach wird mit Diethylether verdünnt und dreimal mit Wasser gewaschen. Anschließend wird die organische Phase separiert und über Natriumsulfat getrocknet. Durch einengen des Lösemittels und chromatographische Trennung über Kieselgel mit dem Eluenten Hexan/Essigester im Verhältnis 10:1 sind 1,02 g (28 %) sauberes Produkt in Form eines weißen Feststoffes zugänglich.
Elemantaranalyse: C 79,99 %; H 6,67 %

### 1.3 Synthese von 1-{4-[5-(4'-tert-Butyl-biphenyl-4-yl)-[1,3,4]oxadiazol-2-yl]-phenyl}-ethanon

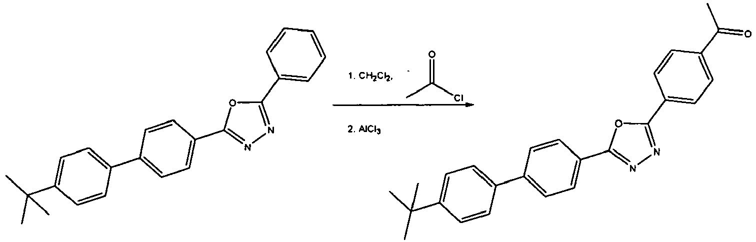

In einen 500 ml Zweihalsrundkolben werden 11,5 g 2-(4'-tert-Butyl-biphenyl-4-yl)-5-phenyl-[1,3,4]oxadiazol (3,24 · 10⁻² mol) in 300 ml Methylenchlorid gelöst, sowie 5,7 ml frisch destilliertes Acetylchlorid (8,20 · 10⁻² mol) und 37 g Aluminiumchlorid (0,24 mol) zugegeben. Nachdem die Reaktionsmischung für 5 h bei Refluxtemperatur gerührt hat, wird das überschüssige Aluminiumchlorid abgesaugt und die Lösung drei Mal mit Wasser gewaschen. Abschließende Trocknung über Natriumsulfat, einengen des Lösemittels und Umkristallisation in Ethanol/Chloroform ergeben 10,00 g (78%) des gewünschten Produktes in sauberer Form als gelbe Kristalle.
Elementaranalyse: C 77,29 %; H 6,39 %; N 6,54 %

### 1.4 Synthese von 1-{4-[5-(4'-tert-Butyl-biphenyl-4-yl)-[1,3,4]oxadiazol-2-yl]phenyl}ethanol

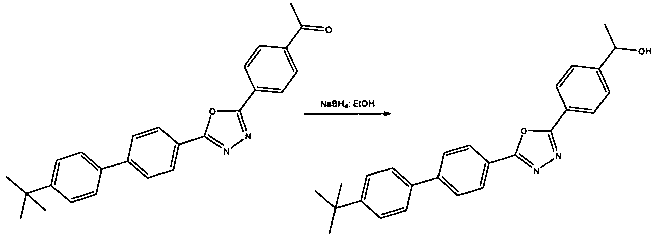

In einen 250 ml Zweihalsrundkolben werden 4,55 g 1-{4-[5-(4'-tert-Butyl-biphenyl-4-yl)-[1,3,4]oxadiazol-2-yl]-phenyl}-ethanol (1,14 · 10⁻² mol) in 100 ml Ethanol gelöst, 1,02 g Natriumborhydrid (2,70 · 10⁻² mol) zugegeben und 5 h bei Raumtemperatur gerührt. Reaktionsabbruch erfolgt durch die Zugabe von 30 ml 2 N HCl, wonach das Reaktionsgemisch in Chloroform aufgenommen und mit Wasser gewaschen wird. Nach Trocknung über Natriumsulfat und einengen des Lösemittels werden 4,40 g (97 %) des sauberen Produktes als hellgelbe Kristalle erhalten.

### 1.5 Synthese von 2-(4'-tert-Butyl-biphenyl-4-yl)-5-(4-vinyl-phenyl)-[1,3,4]oxadiazol

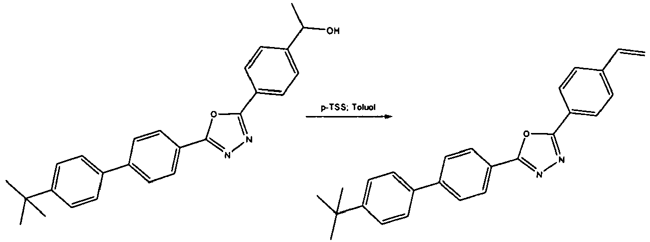

In einen 250 ml Dreihalsrundkolben mit Wasserabscheider und Schlangenkühler werden 4,40 g 1-{4-[5-(4'-tert-Butyl-biphenyl-4-yl)-[1,3,4]oxadiazol-2-yl]-phenyl}-ethanol (1,10 · 10⁻² mol) und 0,22 g p-Toluolsulfonsäure-Monohydrat (1,15 · 10⁻³ mol) in 150 ml Toluol gelöst. Bei Refluxtemperatur wird das entstehende Toluol-Wasser-Azeotrop abdestilliert und anschließend das Lösemittel vollständig abgezogen. Säulenchromatographische Trennung des Rohproduktes über Kieselgel mit dem Eluenten Hexan/Ethylacetat in einer Mischung von 4:1 macht 2,18 g (52 %) sauberes Produkt in Form von weißen Plättchen zugänglich.
Elementaranalyse: C 81,92 %; H 6,62 %; N 7,36 %

### 1.6 Synthese von Di-p-tolyl-(4-vinyl-phenyl)-aminen

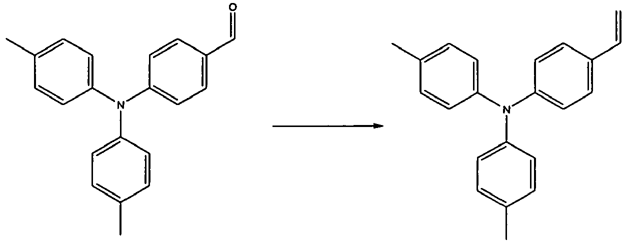

In einen 50 ml Zweihalsrundkolben mit Septum werden 1,48 g Methyltriphenylphosphoniumbromid (4,15 10⁻³ mol) vorgelegt und die Apparatur mehrmals evakuiert und mit Argon geflutet. Anschließend werden über das Septum 10 ml trockenes Toluol und 5 ml trockenes Tetrahydrofuran zugegeben und die Lösung auf 0 °C gekühlt. Nach langsamer Zugabe von 2,6 ml Butyllithium 1,6 M in Hexan (4,15 10⁻³ mol) wird 10 min bei 0 °C gerührt und danach eine Lösung von 0,5 g N,N-Bis(4-methylphenyl)-aminobenzaldehyd (1,66 10⁻³ mol) in wenig trockenem Toluol über das Septum zugespritzt und 2 h bei Raumtemperatur gerührt. Das Rohprodukt wird in Methylenchlorid aufgenommen, mit Wasser gewaschen, über Natriumsulfat getrocknet und am Rotationsverdampfer eingeengt. Säulenchromatographische Trennung mit dem Eluenten Hexan/Ethylacetat im Verhältnis 10:1 (R_{F} = 0,7) ergibt 0,42 g (86 %) sauberes Produkt in Form eines leicht gelben Öles.
Elementaranalyse: C 86,46 %; H 6,99 %; N 4,55 %

### 1.7 Synthese von 2-Methyl-4-{phenyl-[4'-(phenyl-m-tolyl-amino)-biphenyl-4-yl]-amino}benzaldehyd

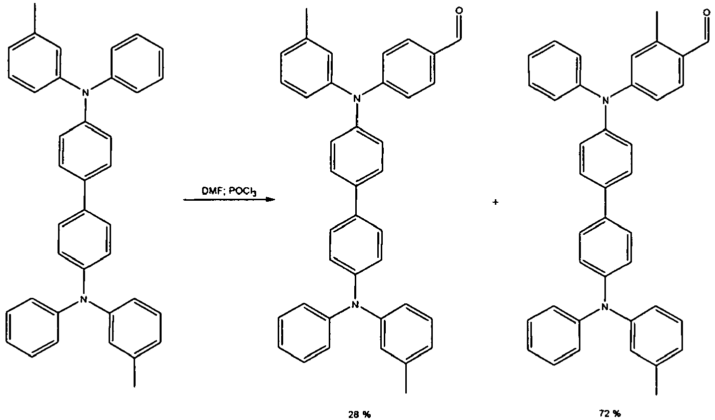

Eine Apparatur bestehend aus 100 ml Dreihalsrundkolben, Schlangenkühler und Septum wird mehrmalig evakuiert, ausgeheizt und mit Argon geflutet. Über das Septum werden 40 ml trockenes Dimethylformamid vorgelegt, auf 0 °C gekühlt und anschließend 2,17 ml Phosphorylchlorid (2,38 10⁻³ mol) zugespritzt. Die Mischung wird 30 Minuten bei 0 °C gerührt, wonach die Zugabe von 10 g N,N-Bis(3-methylphenyl)-N,N-diphenyl-benzidin, gelöst in 30 ml wasserfreiem Dimethylformamid, erfolgt. Nach der Erwärmung auf 80 °C wird für 2 h bei dieser Temperatur gerührt. Nachdem die Reaktionslösung auf Raumtemperatur abgekühlt ist, wird diese vorsichtig in 500 ml 1 M Natriumcarbonat-Lösung gegeben, wodurch ein olivgrüner Feststoff ausfällt, der abgesaugt wird. Durch Lösen in Methylenchlorid, Waschen mit Wasser, Trocknen über Natriumsulfat und Einengen des Lösemittels wird das Rohprodukt erhalten, welches durch säulenchromatographische Trennung über Kieselgel mit dem Eluenten Chloroform/Hexan im Verhältnis 1:1 4,15 g (40 %) sauberes Produkt in Form gelber Kristalle anfällt.

### 1.8 Synthese von Vinyl-TPD

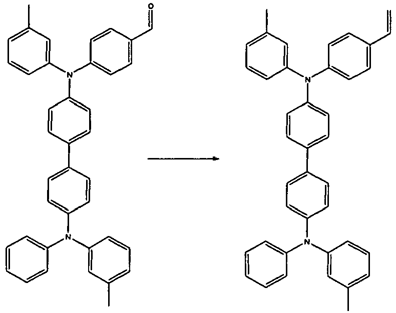

In einen 50 ml Zweihalsrundkolben mit Septum werden 3,37 g Methyltriphenylphosphoniumbromid (1,05 · 10⁻² mol) vorgelegt, wonach die Apparatur mehrmals evakuiert und mit Argon geflutet wird. Über das Septum werden 5 ml trockenes Toluol und 2,5 ml wasserfreies Tetrahydrofuran zugegeben und die Mischung auf 0 °C gekühlt. Anschließend werden 6,56 ml Butyllithium 1,6 M in Hexan (1,05 · 10⁻² mol) langsam zugespritzt und 10 min bei 0 °C gerührt. 5,17 g 2-Methyl-4-{phenyl-[4'-(phenyl-m-tolyl-amino)-biphenyl-4-yl]-amino}-benzaldehyd (9,50 · 10⁻³ mol) werden als Lösung in 5 ml wasserfreiem Toluol zudosiert und die Reaktionsmischung 2 h bei Raumtemperatur gerührt, danach in Methylenchlorid aufgenommen, mit Wasser gewaschen, über Natriumsulfat getrocknet und das Lösemittel eingeengt. Säulenchromatographische Trennung über Kieselgel mit dem Eluenten Hexan/Chloroform 10:1 und abschließende Umkristallisation in Diethylether ergeben 2,3 g (66 %) des gewünschten Produktes in Form eines leicht gelben Feststoffes.
Elementaranalyse: C 88,54 %; H 6,55 %; N 5,07 %

### 1.9 Synthese von {4-[6-(Tetrahydro-pyran-2-yloxy)-hexyl]-phenyl}-di-p-tolyl-amin

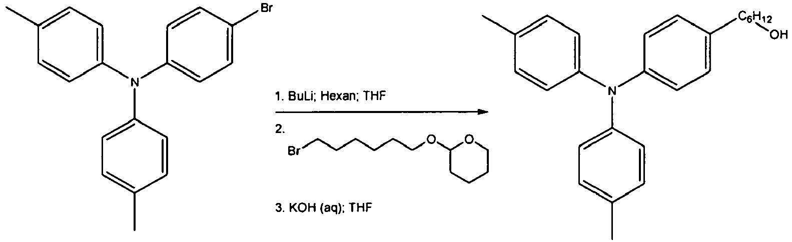

In einen 250 ml Dreihalsrundkolben mit Schlangenkühler, Themometer und Septum werden 5,76 g (4-Bromo-phenyl)-di-p-tolyl-amin (1,64 · 10⁻² mol) vorgelegt und die Apparatur wird anschließend mehrmals evakuiert und mit Argon geflutet. 80 ml wasserfreies Tetrahydrofuran und 80 ml trockenes Hexan werden zugegeben und die Lösung auf -78 °C gekühlt. 10,62 ml Butyllithium 1,6 M in Hexan (1,64 · 10⁻² mol) werden langsam über das Septum zugespritzt und die Mischung für 45 min bei -78°C gerührt, wonach 4,61 g 2-(6-Bromo-hexyloxy)-tetrahydro-pyran (1,80 10⁻² mol) zudosiert und die Reaktionsmischung für ca. 16 h bei Raumtemperatur gerührt wird. Das Rohprodukt wird in Diethylether aufgenommen und mit Wasser gewaschen, über Natriumsulfat getrocknet und das Lösemittel am Rotationsverdampfer eingeengt. Die Rohsubstanz wird in 80 ml Tetrahydrofuran aufgenommen, mit 80 ml 2 N HCl versetzt und bei 50 °C für 2 h ausgerührt. Nach der Separation der organischen Phase wird diese mit gesättigter Natriumbicarbonat-Lösung und anschließend Wasser gewaschen, über Natriumsulfat getrocknet und das Lösemittel eingeengt. Säulenchromatographische Trennung über Kieselgel mit Methylenchlorid als Eluenten macht 4,94 g (80 %) des gewünschten Produktes zugänglich.

### 1.10 Synthese von Di-p-tolyl-{4-[6-(4-vinyl-benzyl-oxy)-hexyl]-phenyl}-amin

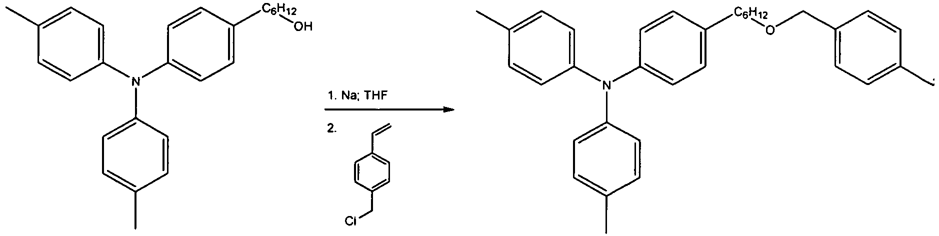

In einen 50 ml Zweihalsrundkolben mit Schlangenkühler und Septum werden 0,15 g Natrium (6,68 10⁻³ mol) in kleinen Portionen eingewogen und die Apparatur mehrmals evakuiert, mit Argon geflutet und dabei ausgeheizt. Danach sind 10 ml wasserfreies Tetrahydrofuran und langsam eine Lösung von 2,50 g {4-[6-(Tetrahydro-pyran-2-yloxy)-hexyl]-phenyl}-di-p-tolyl-amin (6,68 10⁻³ mol) in 10 ml trockenem Tetrahydrofuran zuzuspritzen. Das Reaktionsgemisch wird für ca. 16 h bei 70 °C gerührt und anschließend werden 1,12 g 1-Chloromethyl-4-vinyl-benzen (7,53 10⁻³ mol) zudosiert, wonach die Mischung erneut 16 h bei 70 °C reagiert. Danach wird das Rohprodukt in Diethylether aufgenommen, mit Wasser gewaschen, über Natriumsulfat getrocknet und das Lösemittel eingeengt. Säulenchromatographische Trennung über RP-18-Kieselgel mit dem Eluenten Aceton/Wasser in einem Verhältnis von 10:1 ergibt 2,0 g (61 %) sauberes Produkt.

### 1.11 Synthese von 6-(4-Vinyl-phenyl)-hexan-2,4-dion

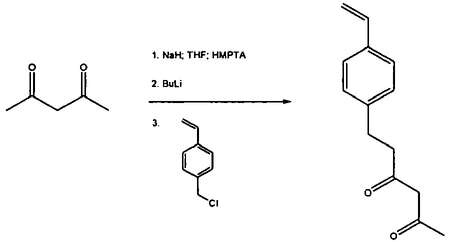

In einen 250 ml Zweihalsrundkolben mit Schlangenkühler und Septum werden 1,97 g Natriumhydrid (8,2 10⁻² mol) vorgelegt und die Apparatur mehrmals evakuiert, mit Argon geflutet und dabei ausgeheizt. 100 ml wasserfreies Tetrahydrofuran sowie 1,6 ml Hexamethylphosphorsäuretriamid werden über das Septum zugegeben und die Mischung wird auf 0 °C gekühlt. 4,00 g Acetylacetonat (4,0 · 10⁻² mol) werden langsam zugespritzt und die Reaktionstemperatur für 20 min bei 0 °C gehalten, wonach 28 ml Butyllithium 1,6 M in Hexan vorsichtig zudosiert werden. Nach weiteren 20 min Reaktionszeit bei 0 °C werden 5,92 ml 1-Chloromethyl-4-vinyl-benzen (4,2 10⁻² mol) zugespritzt, 20 min bei Raumtemperatur gerührt und abschließend mit 2 N HCl leicht angesäuert. Das Rohprodukt wird in Diethylether aufgenommen, mit Natriumbicarbonat-Lösung und Wasser gewaschen, über Natriumsulfat getrocknet und das Lösemittel eingeengt. Säulenchromatographie über Kieselgel mit dem Eluenten Hexan/Dichlormethan 1:1 ergibt 6,80 g (78,8 %) sauberes Produkt in Form eines farblosen Öls.
Elementaranalyse: C 77,89 %; H 7,38 %

### 1.12 Synthese von [Ir(L1)₂(Keton)]

### L1 = z.B. 2-Phenylpyridyl; 2-(2,4-Difluorphe nyl)-pyridin; 2-Benzo[b]thiophen-2-yl-pyridin Keton = 6-(4-Vinyl-phenyl)-hexan-2,4-dion

[{Ir(L1)₂Cl}₂] (0.47 mmol) und Silbertrifluoracetat (0.13 g, 0.94 mmol) werden in 40 mL Aceton gelöst und unter N₂ 1 h unter Rückfluss gekocht. Nachdem die Lösung abgekühlt ist, wird das ausgefallene AgCl abfiltriert. Zur Lösung werden 1 mmol Keton und 0.5 mL Triethylamin gegeben. Die Lösung wird unter Schutzgas über Nacht bei Raumtemperatur gerührt. Das Lösungsmittel wird nun komplett abgezogen und der Rückstand in 10 mL CH₂Cl₂ gelöst und über eine Aluminiumoxidsäule mit Dichlormethan als Eluent chromatographiert. Die erste gelbe Bande enthält das Produkt. Die Lösung wird dann auf ca. 3 mL eingeengt und der Komplex mit Hexan gefällt, abfiltriert und im Vakuum getrocknet.

### 1.13 Synthese von [Ir(ppy)₂(ppy-sty)]

[{Ir(ppy)₂Cl}₂] (0.5 g, 0.47 mmol) wird mit Silbertrifluoracetat (0.13 g, 0.94 mmol) und mit 0.94 mmol 4-Vinylpyridin für 6 h in Methoxyethanol unter Schutzgas am Rückfluss erhitzt. Nachdem die Lösung abgekühlt ist, wird das AgCl abfiltriert und das Filtrat zur Trockene eingeengt. Der Rückstand wird in 10 mL CH₂Cl₂ gelöst und über Aluminiumoxid mit Dichlormethan als Eluens chromatographiert. Die Hauptbande beinhaltet das gewünschte Produkt. Die Fraktion wird auf ca. 3 mL eingeengt und der Feststoff mit Hexan ausgefällt, abfiltriert und im Vakuum getrocknet. Da sich Umlagerungsprodukte bei der Reaktion gebildet haben und die Fraktion offensichtlich Verunreinigungen enthält, muss anschließend eine HPLC durchgeführt werden, bei der der Komplex sauber isoliert werden kann.

### Beispiel 2

### Herstellung von Co- und Terpolymeren

### 2.1 Allgemeine Arbeitsvorschrift

Das vinylfunktionalisierte Monomergemisch wird in einem bestimmten Verhältnis vorgelegt. Die Initiatorkonzentration 2,2-Azobis(2-methylpropionitril) ergibt sich zu 2 Mol-%. Die Monomerkonzentration der Reaktionsmischung beträgt 500 mg · ml⁻¹, Lösemittel ist z.B. inhibitorfreies Tetrahydrofuran bzw. Dimethylformamid oder Toluol. Das Reaktionsgemisch wird unter Inertgasatmosphäre für 60 h bei 50 °C gerührt. Danach wird das Polymer in Methanol ausgefällt und mit Diethylether gewaschen. Erneutes Lösen in Tetrahydrofuran und wiederholtes Ausfällen in Diethylether ergibt das monomerenfreie Polymer in einer Ausbeute von ca. 70 %.

Nach dieser allgemeinen Vorschrift wurde eine Vielzahl verschieden zusammengesetzter Co- und Terpolymere hergestellt. Die Eigenschaften der Polymere sind in den folgenden Tabellen 2 bis 5 zusammengefasst, dabei sind MT313, MT317 sowie MT318 nicht vernetzbare Vergleichsbeispiele. Auf eine derart vernetzte Schicht kann dann eine weitere Schicht aufgebracht werden, ohne den vorhandenen Schichtaufbau zu stören. Dieses Vorgehen kann bei Bedarf mehrfach wiederholt werden, so daß Doppel- und Mehrfachschichtsysteme aufgebaut werden können.

**Tabelle 2**

| Polymer | Struktur | Zusammensetzung / Mol% | | | | | Mn | Mw | Tg |
|---|---|---|---|---|---|---|---|---|---|
| | | Elektronentransportmaterial | Lochtransportmaterial | Emitter | Epoxystyren | Vinylphenol | 10³ g/mol | | °C |
| MT313 | 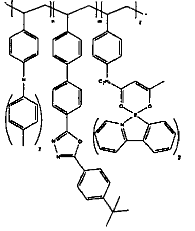 | 66,0 | 31,7 | 2,3 | 0 | 0 | 22,3 | 61,3 | 194 |
| MT317 | 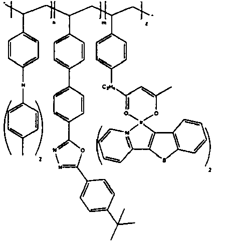 | 67,0 | 30,7 | 2,3 | 0 | 0 | 33,9 | 74,7 | 196 |
| MT318 | 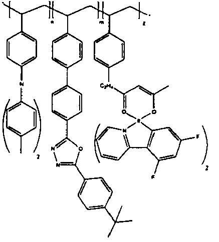 | 66,8 | 31,1 | 2,1 | 0 | 0 | 28,2 | 67,8 | 197 |

**Tabelle 3**

| Polymer | Struktur | Zusammensetzung / Mol% | | | | | Mn | Mw | Tg |
|---|---|---|---|---|---|---|---|---|---|
| | | Elektronentransportmaterial | Lochtransportmaterial | Emitter | Epoxystyren | Vinylphenol | 10³ g/mol | | °C |
| MT243 | 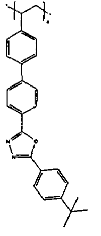 | 100 | 0 | 0 | 0 | 0 | 29,4 | 80,4 | 210 |
| MT359 | 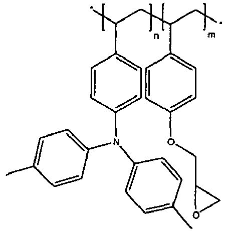 | 0 | 86,0 | 0 | 14,0 | 0 | 29,8 | 59,9 | 141 |
| MT378 | 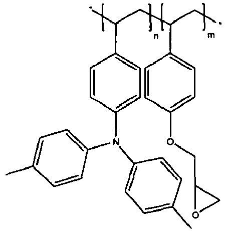 | 0 | 93,0 | 0 | 7,0 | 0 | 19,9 | 42,6 | 134 |

**Tabelle 4**

| Polymer | Struktur | Zusammensetzung / Mol% | | | | | Mn | Mw | Tg |
|---|---|---|---|---|---|---|---|---|---|
| | | Elektronentransportmaterial | Lochtransportmaterial | Emitter | Epoxystyren | Vinylphenol | 10³ g/mol | | °C |
| MT388 | 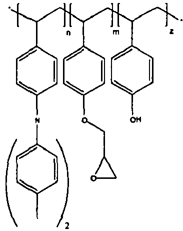 | 0 | 87,0 | 0 | 5,0 | 8,0 | 21,1 | 41,4 | 140 |
| MT406 | 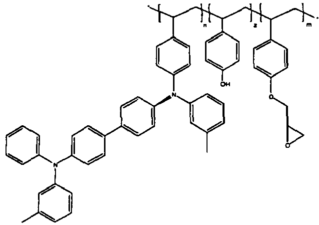 | 0 | 65,0 | 0 | 20,0 | 15,0 | 12,7 | 20,8 | 168 |
| MT383 | 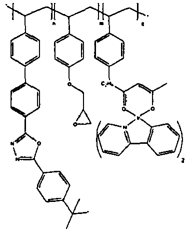 | 91,2 | 0 | 3,8 | 5,0 | 0 | 27,1 | 60,6 | 216 |

**Tabelle 5**

| Polymer | Struktur | Zusammensetzung / Mol% | | | | | Mn | Mw | Tg |
|---|---|---|---|---|---|---|---|---|---|
| | | Elektronentransportmaterial | Lochtransportmaterial | Emitter | Epoxystyren | Vinylphenol | 10³ g/mol | | °C |
| MT405 | 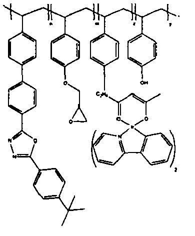 | 83,3 | 0 | 2,0 | 6,9 | 7,8 | 25,1 | 63,9 | 230 |

### 2.2 Aufbau von phosphoreszenten polymeren Leuchtdioden (PhPLED)

### 2.2.1Prinzip des Aufbaus der Mehrfachschichtsysteme

Auf mit einem Indium-Zinn-Oxid (ITO) beschichteten Glassubstrat von ca. 25 cm² wird zunächst eine polymere Zwischenschicht (PEDOT:PSS, BAYTRON^{®}, H.C. Starck) zur Anpassung der Injektionsbarrieren aufgebracht. Das erste lösliche Polymer (meist ein vernetzendes Lochtransportmaterial, z.B. MT359, MT378 und MT388) wird danach durch Spincoating-Technik aufgetragen. Die Schichtdicken liegen im Bereich zwischen 10 nm und 100 nm. Nach dem Entfernen des Lösungsmittels wird die Schicht vernetzt. Dieser Vernetzungsprozess kann in einem Zeitraum von wenigen Sekunden bis zu 1 Stunde, vorzugsweise zwischen 5 und 20 min erfolgen, wobei Temperaturen im Bereich von 130 °C bis 220 °C, vorzugsweise 150 °C bis 180 °C notwendig sind. Danach wird eine weitere Schicht (meist das lösliche Elektronentransportmaterial mit dem kovalent verknüpften Triplettemitter oder einem Blendsystem aus Elektronentransportmaterial mit dem Triplettemitter) wiederum mittels Spincoating-Technik mit Schichtdicken zwischen 10 nm und 100 nm Dicke aufgetragen. Wird diese zweite Schicht ebenfalls vernetzend ausgelegt (z.B. MT383) kann durch einen weiteren Spincoating-Prozess noch eine weitere Schicht aufgetragen werden (dann meistens nur noch ein separater Elektronentransporter z.B. MT243). Anschließend wird eine Cäsiumfluoridschicht von wenigen Nanometern abgeschieden, die von einer Calcium- und Silberschicht durch einen Vakuumprozess erzeugt, geschützt wird.

### 2.2.2 PhPLED Devices mit vernetzbarem Lochtransportcopolymer MT359 und dem Guest-Host-System aus Polystyrenmatrix mit Elektronentransporter und Triplettemitter

Die ITO-Substrate wurden nasschemisch gereinigt. Unmittelbar danach wurden die Substrate in eine Glove-Box eingeschleust. Dort erfolgte das Auftragen der PEDOT:PSS-Schicht und eine Temperung bei 110 °C, die eine Trockenschichtdicke von ca. 60 bis 80 nm zur Folge hat. Die anschließende Präparation des vernetzbaren Copolymers mit dem Vernetzer (p-Phenylendiamin) wurde durch Spincoating hergestellt. Danach erfolgte eine Temperung bei 150 °C für 30 min. Anschließend wurde ein Guest-Host-System bestehend aus Polystyren als Matrix und der Zugabe verschiedener Elektronentransporter (TBPO und TPBI) und dem Triplettemitter ADS066GE mit Hilfe des Spincoatings aufgetragen. Anschließend erfolgte das Aufdampfen der Kathodenstruktur. Dazu wurde eine dünne CsF-Schicht (3 nm) abgeschieden und anschließend Calcium (30 nm) bzw. Barium (30 nm) und Silber (100 nm) aufgedampft.

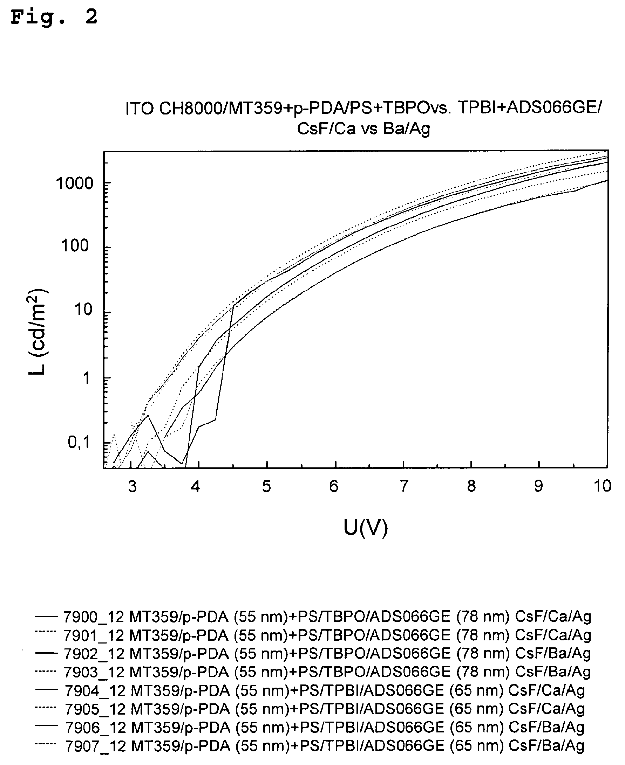

Fig. 2 zeigt eine Helligkeits-Spannungs-Charakteristik einer grünen PhPLED mit MT359 als vernetzte HT-Schicht.

Bei diesen Experimenten wurden Ergebnisse erzielt, die bereits mit Guest-Host-Systemen (dann mit einem zusätzlichen Lochtransportmaterial) erreicht wurden. Die Vernetzung führt damit zu einer Verbesserung der Device-Eigenschaften.

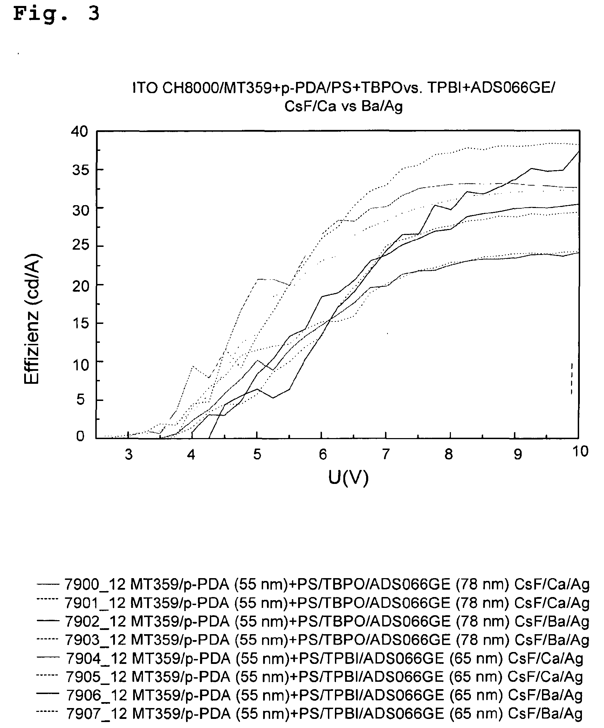

Fig. 3 zeigt eine Effizienz-Spannungs-Charakteristik einer grünen PhPLED mit MT359 als vernetzte HT-Schicht.

Mit diesem Aufbau ließ sich erstmalig die Trennung der Transportschichten in einem polymeren Device erreichen. Es wurden Effizienzen bis zu 37 cd/A erreicht. Beide Elektronentransporter zeigen im Guest-Host-System ihre Funktion. Die Elektronenmaterialien Barium und Calcium zeigen nur geringe Unterschiede in der Performance.

### 2.2.3 PhPLED-Devices mit selbstvernetzendem Lochtransporter MT388 und Guest-Host-System aus Polystyrenmatrix mit Elektronentransporter und Triplettemitter

Die ITO-Substrate wurden nasschemisch gereinigt. Unmittelbar danach wurden die Substrate in eine Glove-Box eingeschleust. Dort erfolgte das Auftragen der PEDOT:PSS-Schicht und eine Temperung bei 110 °C, die eine Trockenschichtdicke von ca. 60 bis 80 nm zur Folge hat. Die ITO-Substrate wurden nasschemisch gereinigt. Unmittelbar danach wurden die Substrate in eine Glove-Box eingeschleust. Dort erfolgte das Auftragen der PEDOT:PSS-Schicht und eine Temperung bei 110 °C, die eine Trockenschichtdicke von ca. 60 bis 80 nm zur Folge hat. Die anschließende Präparation selbstvernetzenden Copolymers wurde durch Spincoating hergestellt. Danach erfolgte eine Temperung bei 150 °C für 30 min. Anschließend wurde ein Guest-Host-System bestehend aus Polystyren als Matrix und der Zugabe eines Elektronentransporters (TBPO) und dem Triplettemitter ADS066GE mit Hilfe des Spincoatings aufgetragen. Anschließend erfolgte das Aufdampfen der Kathodenstruktur. Anschließend wurde zunächst eine dünne CsF-Schicht (3 nm) abgeschieden und Calcium (30 nm) und Silber (100 nm) aufgedampft.

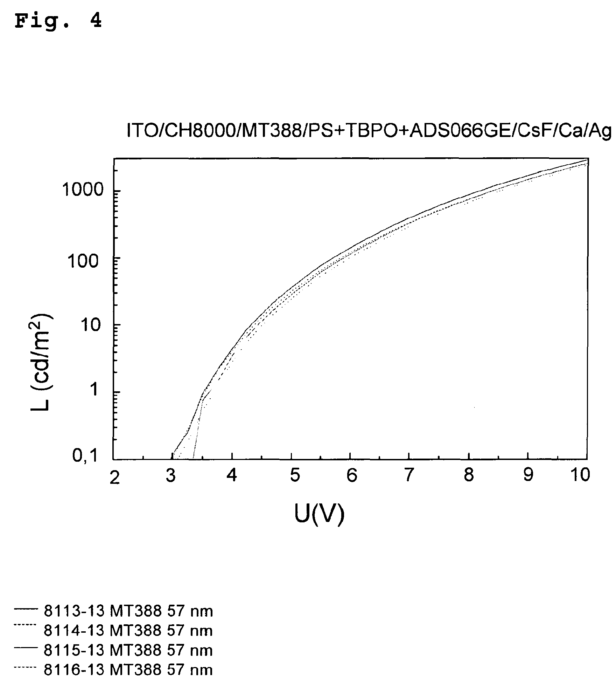

Fig. 4 zeigt eine Effizienz-Spannungs-Charakteristik einer grünen PhPLED mit MT88 als selbstvernetzte HT-Schicht.

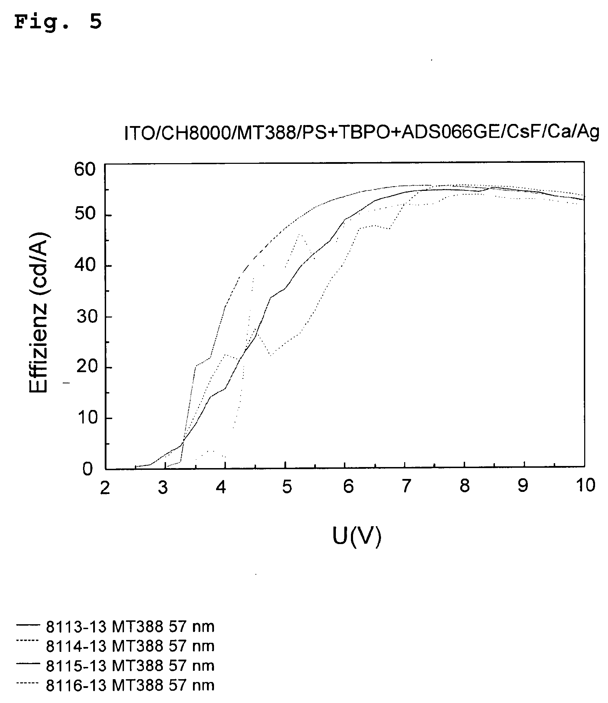

Fig. 5 zeigt eine Effizienz-Spannungs-Charakteristik einer grünen PhPLED mit MT388 als selbstvernetzte HT-Schicht.

Es wurden Effizienzen bis zu 55 cd/A erreicht. Das selbstvernetzende System in Kombination mit dem Guest-Host-System führt damit zu noch effizienteren Systemen gegenüber denjenigen, die eine zusätzliche Vernetzungskomponente erfordern (s. 2.2.2).

### 2.2.4 Aufbau eines Doppelschichtsystems bestehend aus selbstvernetzendem Lochtransporter MT388 und einem Copolymer aus Elektronentransporter und Triplettemitter MT382

Auf mit einem Indium-Zinn-Oxid (ITO) beschichteten Glassubstrat von ca. 25 cm² wird zunächst eine polymere Zwischenschicht PEDOT:PSS zur Anpassung der Injektionsbarrieren aufgebracht. Das selbstvernetzende Lochtransportermaterial MT388 wird danach durch Spincoating-Technik aufgetragen. Die Schichtdicken liegen im Bereich zwischen 10 nm und 100 nm. Nach dem Entfernen des Lösungsmittels wird die Schicht vernetzt. Dieser Vernetzungsprozess kann in einem bestimmten Zeitraum von wenigen Sekunden bis zu 1 Stunde erfolgen, wobei Temperaturen im Bereich von 130 °C bis 220°C unter normaler Atmosphäre notwendig sind. Danach wird eine weitere Schicht aus einem Copolymer aus Elektronentransportmaterial und kovalent verknüpftem Triplettemitter wiederum mittels Spincoating-Technik mit Schichtdicken zwischen 10 nm und 100 nm Dicke aufgetragen. Anschließend erfolgte das Aufdampfen der Kathodenstruktur. Dazu wurde eine dünne CsF-Schicht (3 nm) abgeschieden und anschließend Calcium (30 nm) und Silber (100 nm) aufgedampft.

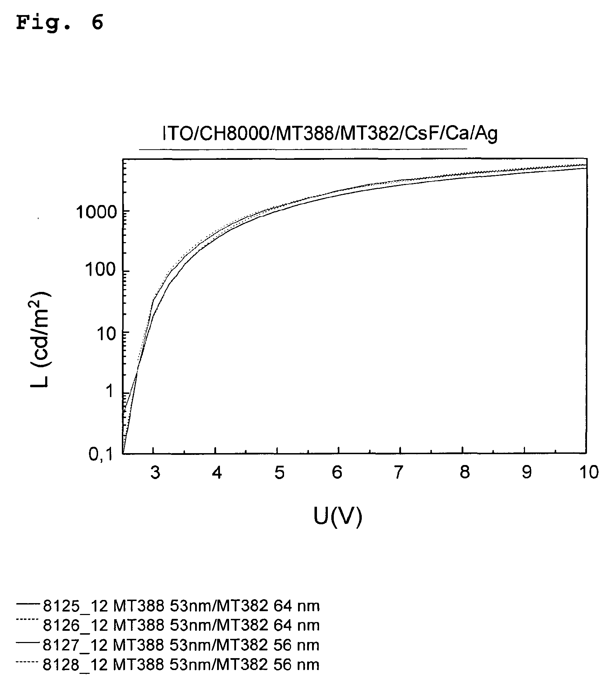

Fig. 6 zeigt eine Effizienz-Spannungs-Charakteristik einer grünen PhPLED mit MT388 als selbstvernetzte HT-Schicht und einem Copolymer aus Elektronentransporter und Triplettemitter MT382.

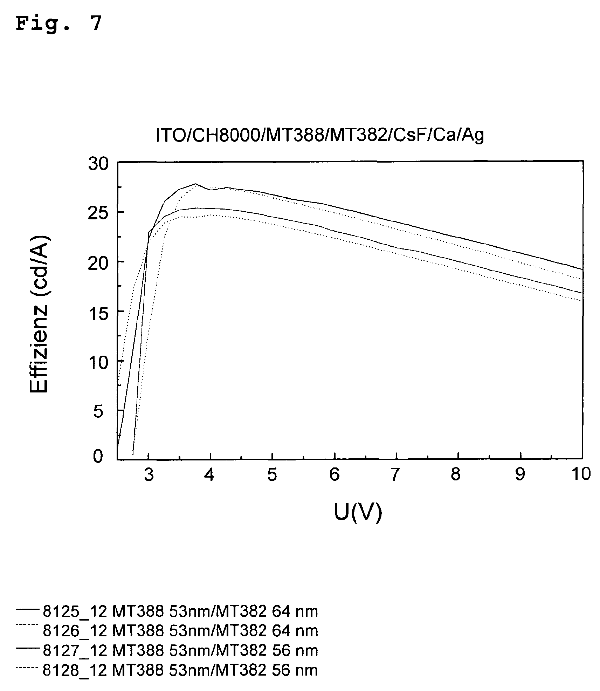

Fig. 7 zeigt eine Effizienz-Spannungs-Charakteristik einer grünen PhPLED mit MT388 als selbstvernetzte HT-Schicht und einem Copolymer aus Elektronentransporter und Triplettemitter MT382.

### 2.2.5 Aufbau eines Mehrfachschichtsystems aus selbstvernetzendem Lochtransporter MT388, einem Copolymer aus Elektronentransporter und Triplettemitter mit Vernetzungsmöglichkeit MT383 und separatem Elektronentransporter MT243

Auf mit einem Indium-Zinn-Oxid (lTO) beschichteten Glassubstrat von ca. 25 cm² wird zunächst eine polymere Zwischenschicht PEDOT:PSS zur Anpassung der Injektionsbarrieren aufgebracht. Das erste selbstvernetzende Lochtransportmaterial MT388 wird danach durch Spincoating Technik aufgetragen. Die Schichtdicken liegen im Bereich zwischen 10 nm und 100 nm. Nach dem Entfernen des Lösungsmittels wird die Schicht vernetzt. Dieser Vernetzungsprozess kann in einem bestimmten Zeitraum von wenigen Sekunden bis zu 1 Stunde erfolgen, wobei Temperaturen im Bereich von 130 °C bis 220°C unter normaler Atmosphäre notwendig sind. Danach wird eine weitere Schicht bestehend aus einem vernetzenden System mit Elektronentransportmaterial mit dem kovalent verknüpften Triplettemitter MT383 wiederum mittels Spincoating-Technik mit Schichtdicken zwischen 10 nm und 100 nm Dicke aufgetragen. Diese zweite Schicht wird ebenfalls bei Temperaturen im Bereich von 130 °C bis 220 °C vernetzt in einem Zeitraum von wenigen Sekunden bis zu einer Stunde. Danach erfolgt die Abscheidung einer Elektronentransportschicht (MT243). Anschließend erfolgt das Aufdampfen der Kathodenstruktur. Anschließend wurde eine dünne CsF-Schicht (3 nm) abgeschieden und Calcium (30 nm) und Silber (100 nm) aufgedampft.

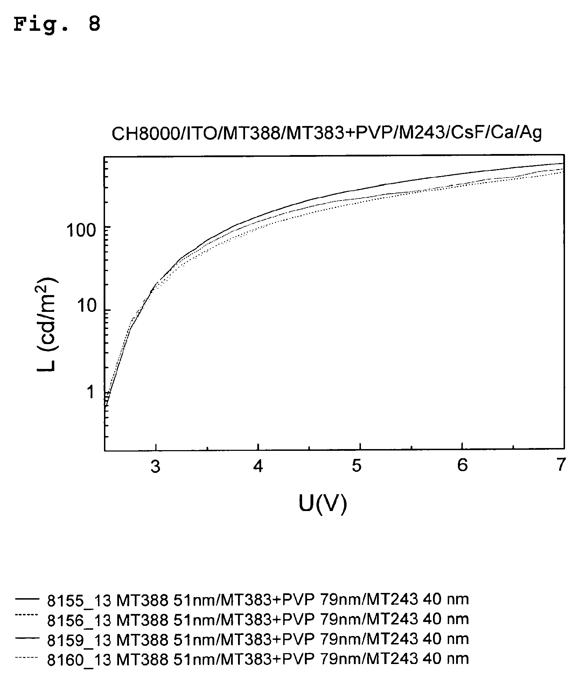

Fig. 8 zeigt eine Helligkeits-Spannungs-Charakteristik einer grünen PhPLED mit MT388/MT383/MT243 als Mehrfachschichtsystem.

Die hier erreichten Helligkeiten und Effizienzen zeigen, dass es möglich ist, eine Dreifachschichtanordnung in einer phosphoreszenten polymeren Leuchtdiode umzusetzen.

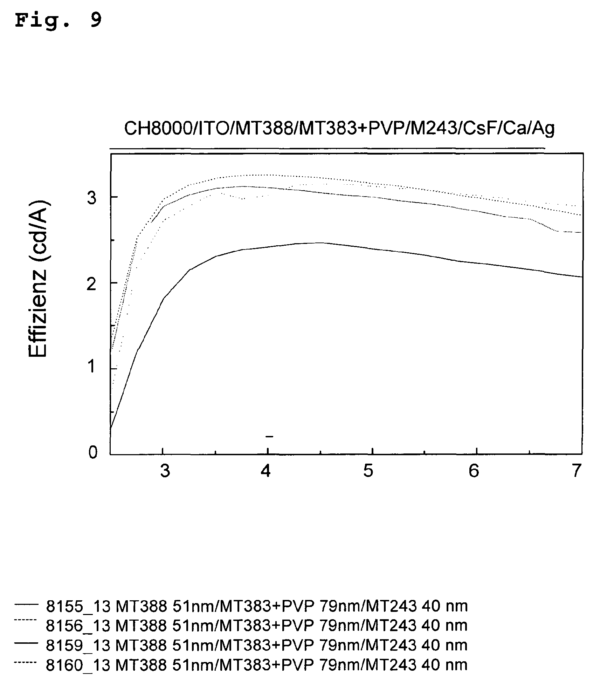

Fig. 9 zeigt eine Effizienz-Spannungs-Charakteristik einer grünen PhPLED mit MT388/MT383/MT243 als Mehrfachschichtsystem.

### 2.2.6 Zusammenfassung der Device-Charakterisierung

Es konnte an unterschiedlichen Device-Strukturen von vernetzenden Polymerstrukturen nachgewiesen werden, dass phosphoreszente polymere Leuchtdioden aufgebaut werden können. Dazu wurden unterschiedliche Vernetzungsmethoden angewandt und deren Eignung in Kombination mit Guest-Host-Systemen und Copolymeren getestet. Die Ergebnisse in Tabelle 6 zeigen, dass sehr effiziente Device-Strukturen (bis 55 cd/A) möglich sind.

**Tabelle 6**

| Schicht 1 | Schicht 2 | Schicht 3 | Helligkeit in cd/m² | Effizienz in cd/A |
|---|---|---|---|---|
| MT359 | PS+ET+TE | | 3000 @ 10 V | 37 @ 8 V |
| MT388 | PS+ET+TE | | 2000 @ 10 V | 55 @ 7 V |
| MT388 | MT382 | | 5000 @ 10 V | 28 @ 3 V |
| MT388 | MT383 | MT243 | 500 @ 10 V | 3 @ 3 V |

## Patentansprüche

1. Verfahren zur Herstellung polymerer Licht emittierender Dioden mit folgenden Schritten:
a) Aufbringen einer ersten Lösung enthaltend mindestens ein Lochtransportermaterial und mindestens ein thermisch vernetzbares Polymer auf eine transparente Anode,
b) thermische Vernetzung der Polymere unter Ausbildung einer ersten Schicht,
c) Aufbringen einer zweiten Lösung enthaltend mindestens einen Phosphoreszenzemitter und mindestens ein thermisch vernetzbares Polymer auf der ersten Schicht,
d) thermische Vernetzung der Polymere unter Ausbildung einer zweiten Schicht und
e) zumindest bereichsweises Aufbringen mindestens eines Metalls als Kathodenmaterial auf der zweiten Schicht.

2. Verfahren nach dem vorhergehenden Anspruch, **dadurch gekennzeichnet, dass** die erste Lösung zusätzlich mindestens einen Phosphoreszenzemitter enthält und/oder die zweite Lösung zusätzlich mindestens ein Elektronentransportmaterial und/oder ein Lochtransportmaterial enthält.

3. Verfahren nach einem der vorhergehenden Ansprüche, **dadurch gekennzeichnet, dass** nach Schritt d) auf der zweiten Schicht eine dritte Lösung enthaltend mindestens einen Phosphoreszenzemitter, mindestens ein Elektronentransportmaterial und mindestens ein thermisch vernetzbares Polymer aufgebracht und anschließend das Polymer thermisch vernetzt wird.

4. Verfahren nach einem der vorhergehenden Ansprüche, **dadurch gekennzeichnet, dass** der mindestens eine Phosphoreszenzemitter ausgewählt ist aus der Gruppe bestehend aus organischen Metallkomplexen mit Zentralatomen der Elemente Re, Ir, Pt, Eu, Ru, Komplexen von anderen Seltenerdmetallen und/oder deren Mischungen.

5. Verfahren nach einem der vorhergehenden Ansprüche, **dadurch gekennzeichnet, dass** das Lochtransportmaterial ausgewählt ist aus der Gruppe bestehend aus Arylaminen, Carbazole, carbazolsubstituierte Verbindungen und Mischungen hiervon.

6. Verfahren nach einem der vorhergehenden Ansprüche, **dadurch gekennzeichnet, dass** das Elektronentransportmaterial ausgewählt ist aus der Gruppe bestehend aus Oxadiazolen, Triazolen, Chinoxalinen, Chinolinen, Phenanthrenen, Bathocuproinen, Benzimidazolen und Mischungen hiervon.

7. Verfahren nach einem der vorhergehenden Ansprüche, **dadurch gekennzeichnet, dass** die Lochtransportmaterialien, Elektronentransportmaterialien und/oder Phosphorezenzemitter selbst die thermisch vernetzbaren Polymere darstellen, wobei diese durch Copolymerisation reaktiver Gruppen vernetzbar modifiziert wurden, und wobei die reaktiven Gruppen insbesondere ausgewählt sind aus Epoxidgruppen, phenolischen Hydroxygruppen und/oder aromatischen Aminogruppen.

8. Verfahren nach einem der Ansprüche 1 bis 6, **dadurch gekennzeichnet, dass** das thermisch vernetzbare Polymer ein im sichtbaren Bereich nicht emittierendes Polymer ist.

9. Verfahren nach einem vorhergehenden Anspruch, **dadurch gekennzeichnet, dass** das thermisch vernetzbare Polymer ausgewählt ist aus der Gruppe der Styrole und die Lochtransportmaterialien, Elektronentransportmaterialien und/oder Phosphoreszenzemitter in das Polymer eingemischt werden.

10. Verfahren nach einem der vorhergehenden Ansprüche, **dadurch gekennzeichnet, dass** vor dem Aufbringen der ersten Lösung auf der transparenten Anode eine polymere Zwischenschicht zur Anpassung der Injektionsbarriere abgeschieden wird und/oder die Schichten in einer Dicke im Bereich von 10 bis 500 nm, insbesondere von 10 bis 100 nm aufgebracht werden.

11. Polymere Licht emittierende Diode (PLED) enthaltend mindestens eine transparente Elektrode als Anode, mindestens eine Metallelektrode als Kathode sowie ein organisches, Licht emittierendes Mehrschichtsystem aus thermisch vernetzten Polymerschichten, wobei das Schichtsystem mindestens eine erste, ein Lochtransportmaterial enthaltende Schicht und eine zweite, mindestens einen Phosphoreszenzemitter enthaltende Schicht aufweist.

12. Polymere Licht emittierende Diode nach Anspruch 11, **dadurch gekennzeichnet, dass** das Lochtransportmaterial und/oder der Phosphorezenzemitter kovalent in dem thermisch vernetzten Polymer gebunden ist.

13. Polymere Licht emittierende Diode nach einem der Ansprüche 11 bis 12, **dadurch gekennzeichnet, dass** das vernetzte Polymer über Epoxygruppen, phenolische oder aminische Funktionalitäten vernetzt wurde und/oder die erste Schicht benachbart zur transparenten Anode angeordnet ist und/oder die erste Schicht zusätzlich mindestens einen Phosphoreszenzemitter enthält und/oder die zweite Schicht auf der der transparenten Anode abgewandten Seite der ersten Schicht angeordnet ist und/oder die zweite Schicht mindestens ein Elektronentransportmaterial und/oder mindestens ein Lochtransportmaterial enthält.

14. Polymere Licht emittierende Diode nach einem der Ansprüche 11 bis 13, **dadurch gekennzeichnet, dass** die Schichten eine Dicke im Bereich von 10 bis 500 nm, insbesondere 10 bis 100 nm aufweisen und/oder die transparente Anode aus Indium-Zinn-Oxid (ITO) besteht oder dieses im wesentlichen enthält.

## Claims

1. Method for producing polymer light-emitting diodes having the following steps:
a) applying a first solution containing at least one hole transport material and at least one polymer which is able to be thermally cross-linked to a transparent anode,
b) thermal cross-linking of the polymers, forming a first layer,
c) applying a second solution containing at least one phosphorescence emitter and at least one polymer which is able to be thermally cross-linked to the first layer,
d) thermal cross-linking of the polymers, forming a second layer and
e) applying, at least in regions, at least one metal to the second layer as a cathode material.

2. Method according to the preceding claim, **characterised in that** the first solution additionally contains at least one phosphorescence emitter and/or the second solution additionally contains at least one electron transport material and/or a hole transport material.

3. Method according to one of the preceding claims, **characterised in that** after step d), a third solution containing at least one phosphorescence emitter, at least one electron transport material and at least one polymer which is able to be thermally cross-linked is applied to the second layer, and then the polymer is thermally cross-linked.

4. Method according to one of the preceding claims, **characterised in that** the at least one phosphorescence emitter is selected from the group consisting of organic metal complexes with central atoms of the elements Re, Ir, Pt, Eu, Ru, complexes of other rare earth metals and/or mixtures thereof.

5. Method according to one of the preceding claims, **characterised in that** the hole transport material is selected from the group consisting of arylamines, carbazoles, carbazole-substituted compounds and mixtures thereof.

6. Method according to one of the preceding claims, **characterised in that** the electron transport material is selected from the group consisting of oxadiazoles, triazoles, quinoxalines, quinolines, phenanthrenes, bathocuproines, benzimidazoles and mixtures thereof.

7. Method according to one of the preceding claims, **characterised in that** the hole transport materials, electron transport materials and/or phosphorescence emitters themselves represent the polymers which are able to be thermally cross-linked, wherein these were modified to be able to be cross-linked by copolymerisation of reactive groups, and wherein the reactive groups are in particular selected from epoxy groups, phenolic hydroxy groups and/or aromatic amino groups.

8. Method according to one of claims 1 to 6, **characterised in that** the polymer which is able to be thermally cross-linked is a polymer which does not emit in the visible range.

9. Method according to a preceding claim, **characterised in that** the polymer which is able to be thermally cross-linked is selected from the group of styrenes and the hole transport materials, electron transport materials and/or phosphorescence emitters are mixed into the polymer.

10. Method according to one of the preceding claims, **characterised in that**, before applying the first solution to the transparent anode, a polymer intermediate layer for adapting the injection barrier is deposited and/or the layers are applied at a thickness in the range from 10 to 500nm, in particular from 10 to 100nm.

11. Polymer light-emitting diode (PLED) containing at least one transparent electrode as an anode, at least one metallic electrode as a cathode as well as an organic, light-emitting multilayer system made from thermally cross-linked polymer layers, wherein the layer system has at least one first layer containing a hole transport material and a second layer containing at least one phosphorescence emitter.

12. Polymer light-emitting diode according to claim 11, **characterised in that** the hole transport material and/or the phosphorescence emitter is connected covalently in the thermally cross-linked polymer.

13. Polymer light-emitting diode according to one of claims 11 to 12, **characterised in that** the cross-linked polymer was cross-linked via epoxy groups, phenolic or aminic functionalities and/or the first layer is arranged to be adjacent to the transparent anode and/or the first layer additionally contains at least one phosphorescence emitter and/or the second layer is arranged on the side of the first layer facing away from the transparent anode and/or the second layer contains at least one electron transport material and/or at least one hole transport material.

14. Polymer light-emitting diode according to one of claims 11 to 13, **characterised in that** the layers have a thickness in the range from 10 to 500nm, in particular 10 to 100nm and/or the transparent anode consists of indium tin oxide (ITO) or substantially contains this.

## Revendications

1. Procédé de fabrication de diodes polymères électroluminescentes, comprenant les étapes suivantes :
a) application, sur une anode transparente, d'une première solution contenant au moins un matériau de transport de trous et au moins un polymère thermoréticulable,
b) thermoréticulation des polymères avec formation d'une première couche,
c) application, sur la première couche, d'une deuxième solution contenant au moins un émetteur de phosphorescence et au moins un polymère thermoréticulable,
d) thermoréticulation des polymères, avec formation d'une deuxième couche, et
e) application au moins par zones, sur la deuxième couche, d'au moins un métal en tant que matériau de cathode.

2. Procédé selon la revendication précédente, **caractérisé en ce que** la première solution contient en outre au moins un émetteur de phosphorescence, et/ou la deuxième solution contient en outre au moins un matériau de transport d'électrons et/ou un matériau de transport de trous.

3. Procédé selon l'une des revendications précédentes, **caractérisé en ce que**, après l'étape d), on applique sur la deuxième couche une troisième solution contenant au moins un émetteur de phosphorescence, au moins un matériau de transport d'électrons et au moins un polymère thermopolymérisable, puis on soumet le polymère à une thermoréticulation.

4. Procédé selon l'une des revendications précédentes, **caractérisé en ce que** le ou les émetteurs de phosphorescence sont choisis dans le groupe consistant en les complexes métalliques organiques avec atomes centraux des éléments Re, Ir, Pt, Eu, Ru, les complexes d'autres métaux de terres rares, et/ou les mélanges de ceux-ci.

5. Procédé selon l'une des revendications précédentes, **caractérisé en ce que** le matériau de transport de trous est choisi dans le groupe consistant en les arylamines, les carbazoles, les composés à substitution carbazole et les mélanges de ceux-ci.

6. Procédé selon l'une des revendications précédentes, **caractérisé en ce que** le matériau de transport d'électrons est choisi dans le groupe consistant en les oxadiazoles, les triazoles, les quinoxalines, les quinoléines, les phénanthrènes, les bathocuproïnes, les benzimidazoles et les mélanges de ceux-ci.

7. Procédé selon l'une des revendications précédentes, **caractérisé en ce que** les matériaux de transport de trous, les matériaux de transport d'électrons et/ou les émetteurs de phosphorescence représentent par eux-mêmes le polymère thermoréticulable, ce dernier pouvant être modifié, pour être réticulable, par copolymérisation des groupes réactifs, et les groupes réactifs étant en particulier choisis parmi les groupes époxydes, les groupes hydroxyphénoliques et les groupes amino aromatiques.

8. Procédé selon l'une des revendications 1 à 6, **caractérisé en ce que** le polymère thermoréticulable est un polymère qui n'émet pas dans le domaine visible.

9. Procédé selon l'une des revendications précédentes, **caractérisé en ce que** le polymère thermoréticulable est choisi dans le groupe des styrènes, et les matériaux de transport de trous, les matériaux de transport d'électrons et/ou les émetteurs de phosphorescence sont incorporés par mélange dans le polymère.

10. Procédé selon l'une des revendications précédentes, **caractérisé en ce que**, avant application de la première solution sur l'anode transparente, on dépose une couche intermédiaire polymère pour l'adaptation de la barrière d'injection, et/ou les couches sont appliquées sur une épaisseur comprise dans la plage de 10 à 500 nm, en particulier de 10 à 100 nm.

11. Diode polymère électroluminescente (PLED) contenant au moins une électrode transparente en tant qu'anode, au moins une électrode négative en tant que cathode, ainsi qu'un système multicouche organique électroluminescent constitué de couches polymères thermoréticulées, le système de couches comprenant au moins une première couche contenant un matériau de transport de trous et une deuxième couche contenant au moins un émetteur de phosphorescence.

12. Diode polymère électroluminescente selon la revendication 11, **caractérisée en ce que** le matériau de transport de trous et/ou l'émetteur de phosphorescence sont liés par liaison covalente dans le polymère thermoréticulable.

13. Diode polymère électroluminescente selon l'une des revendications 11 à 12, **caractérisée en ce que** le polymère réticulé a été réticulé par l'intermédiaire de groupes époxy, de fonctionnalités phénoliques ou aminées, et/ou que la première couche est disposée au voisinage de l'anode transparente, et/ou que la première couche contient en outre au moins un émetteur de phosphorescences et/ou que la deuxième couche est disposée sur le côté de la première couche opposé à l'anode transparente, et/ou que la deuxième couche contient au moins un matériau de transport d'électrons et/ou au moins un matériau de transport de trous.

14. Diode polymère électroluminescente selon l'une des revendications 11 à 13, **caractérisée en ce que** les couches présentent une épaisseur comprise dans la plage de 10 à 500 nm, en particulier de 10 à 100 nm, et/ou l'anode transparente est constituée d'oxyde d'indium et d'étain (ITO) ou le contient pour l'essentiel.
